# EUROPÄISCHE PATENTSCHRIFT

(11) **EP 1 817 949 B1**
(45) Veröffentlichungstag und Bekanntmachung des Hinweises auf die Patenterteilung: **27.02.2008**
(21) Anmeldenummer: 06701797.0
(22) Anmeldetag: 26.01.2006
(51) Int. Cl.: H05K 7/20

(54) **VORRICHTUNG ZUM KÜHLEN EINES ELEKTRISCHEN ODER ELEKTRONISCHEN GERÄTS IN EINEM SCHALTSCHRANK**
DEVICE FOR COOLING AN ELECTRICAL OR ELECTRONIC DEVICE IN A SWITCH CABINET
DISPOSITIF DESTINE A REFROIDIR UN APPAREIL ELECTRIQUE OU ELECTRONIQUE SITUE DANS UNE ARMOIRE ELECTRIQUE

(30) Priorität: 02.03.2005 DE 202005003380 U
(43) Veröffentlichungstag der Anmeldung: 15.08.2007
(73) Patentinhaber: Brinkmann GmbH & Co. KG, 32683 Barntrup (DE)
(72) Erfinder: FRITZENSMEIER, Thomas, 32657 Lemgo (DE)
(74) Vertreter: Schenk, Markus
(86) Internationale Anmeldenummer: PCT/EP2006/000697
(87) Internationale Veröffentlichungsnummer: WO 2006/092192

(56) Entgegenhaltungen:
- EP-A- 0 454 123
- DE-A1- 10 326 803
- US-A- 3 481 393

## Beschreibung

Die vorliegende Erfindung bezieht sich auf eine Vorrichtung zum Kühlen eines in einem Schaltschrank angeordneten elektrischen oder elektronischen Geräts, und bezieht sich insbesondere auf eine solche Vorrichtung, die die Nutzung eines externen Flüssigkeitskreislaufs ermöglicht, ohne Komponenten des elektrischen oder elektronischen Geräts durch den externen Flüssigkeitskreislauf zu kontaminieren. Insbesondere bezieht sich die vorliegende Erfindung auf eine Vorrichtung, die zum Kühlen von Frequenzumrichtern geeignet ist, die zur variablen Einstellung der Motordrehzahl von elektrischen Motoren bei vollem Drehmoment dienen.

Generell werden Frequenzumrichter zum Betrieb von elektrischen Motoren in luftgekühlter Ausführung gefertigt und am Markt vertrieben. Da sich die Verlustleistung von Frequenzumrichtern im wesentlichen aus den Endstufenverlusten zusammensetzt, bieten sich im höheren Leistungsbereich flüssigkeitsgekühlte Frequenzumrichter an. Die Flüssigkeitskühlkörper erlauben eine effektive Kühlung der Leistungshalbleiter.

In der Kunststoffmaschinenbranche wird an den Kunststoffverarbeitungsmaschinen, beispielsweise Extrudern oder Spritzgussmaschinen, allgemein Wasser benötigt. Bei Nutzern, die derartige Kunststoffverarbeitungsmaschinen einsetzen, ist daher in der Regel ein Wasserkreislauf mit Temperaturen von weniger als 20°C, typischerweise 6 bis 15°C, bei einem Standarddruck von 6 Bar vorhanden. Derartige bestehende Systeme wurden seit etwa 1998 unter Verwendung eines Wasserkühlkörpers zum Kühlen von Frequenzumrichtern angezapft, wobei der Wasserkühlkörper außerhalb des Schaltschranks angeordnet war. Wie ausgeführt wurde, herrschen im Bereich von Kunststoffmaschinen in der Regel 6 Bar Betriebsdruck in dem Wasserkreislauf, der bei dem Benutzer vorhanden ist. Der hohe Druck von 6 Bar verbietet es, den Wasserkreislauf innerhalb elektrischer Anlagen, wie beispielsweise einem Schaltschrank, zu führen. Lösungen können hier nur so aussehen, dass der druckbelastete Wasserkreislauf außerhalb der Schaltschränke untergebracht wird. Somit werden seit 1998 flüssigkeitsgekühlte Frequenzumrichter in Schaltschrankdurchsteckversion gefertigt.

Bei dem oben beschriebenen Lösungsansatz wird das Kühlmedium, in der Regel Wasser, welches von dem Benutzer zur Verfügung gestellt wird, direkt für die Kühlung genutzt. Da seitens der Benutzer bzw. Endkunden die verschiedensten Wasserqualitäten angetroffen werden, kann dieses mittel- bis langfristig zu Problemen an den flüssigkeitsgekühlten Antriebsaggregaten wie Motor, Getriebe und Frequenzumrichter führen. Die Kühlkanäle können sich durch Ablagerungen zusetzen, oder Systeme können durch aggressive Kühlmedien angegriffen und somit undicht werden.

Die der vorliegenden Erfindung zugrunde liegende Aufgabe besteht darin, eine Vorrichtung zum Kühlen eines in einem Schaltschrank angeordneten elektrischen oder elektronischen Geräts zu schaffen, die es bei einem einfachen Aufbau ermöglicht, einen bei einem Benutzer vorhandenen Flüssigkeitskreislauf zum Kühlen des elektrischen oder elektronischen Geräts zu verwenden, ohne dass schwer zugängliche Komponenten anfällig für eine schlechte Qualität der Flüssigkeit des Flüssigkeitskreislaufes sind.

Diese Aufgabe wird durch eine Vorrichtung gemäß Anspruch 1 gelöst.

Die vorliegende Erfindung schafft eine Vorrichtung zum Kühlen eines in einem Schaltschrank angeordneten elektrischen oder elektronischen Geräts, mit folgenden Merkmalen:
einem Sekundärkühlkörper für einen Sekundärkühlkreislauf, wobei der Sekundärkühlkörper an dem elektrischen oder elektronischen Gerät angebracht ist, um dasselbe zu kühlen, und wobei zumindest ein Abschnitt des Sekundärkühlkühlkörpers durch eine Öffnung in einer Wand des Schaltschranks aus demselben vorsteht; und einem Primärkühlkörper für einen Primärkreislauf, der auf dem aus dem Schaltschrank vorstehenden Abschnitt des Sekundärkühlkörper abnehmbar angebracht ist, um denselben zu kühlen.

Gemäß der vorliegenden Erfindung wird das im Stand der Technik existierende Problem dahingehend gelöst, dass ein Sekundärkühlkörper für einen sekundären, in sich geschlossenen Kühlkreislauf aufgebaut wird. Der sekundäre Kühlkreislauf wird dann mit einem fest definierten Kühlmedium gefüllt, beispielsweise destilliertes Wasser mit einem Glykolanteil. Dieser sekundäre Kühlkreislauf kann für eine komplette Maschine aufgebaut werden. Die Umsetzung obliegt somit dem Maschinenbauer.

In der heutigen Zeit geht der Trend immer mehr in Richtung Systembauweise. Somit kommt dem Antriebslieferanten bzw. Antriebshersteller d.h. dem Lieferanten bzw. Hersteller, der einen elektrischen Motor, für den beispielsweise ein Frequenzumrichter benötigt wird, bereitstellt, die Aufgabe zu, für seine komplette Antriebsachse einen separaten Kühlkreislauf mit anzubieten. Somit sieht sich der Antriebshersteller vor der Aufgabe, zusätzlich zu seinen klassischen Einheiten Komponenten für einen sekundären Wasserkreislauf zu erarbeiten und mit zu vertreiben. Hier kann der Antriebshersteller auf fertige Lösungen aus der Zulieferindustrie zurückgreifen, wie beispielsweise fertig aufgebaute Temperiergeräte. Alternativ wählt er eine klassische Lösung mittels Verwendung von Wärmeübertrager (Wasser-/Wassertauscher) im Zusammenspiel mit Umwälzpumpe und Ausgleichsbehälter, unter Verwendung üblicher Heizungsbauartikel.

Wird ein Frequenzumrichter mit einer Netzdrossel und einem Funkstörspannungsfilter in einem Schaltschrank aufgebaut, müsste zusätzlich Platz für die Umwälzpumpe, den Ausgleichsbehälter mit Überdruckventil und einen Wärmeübertrager (Wasser/Wassertauscher) mit eingeplant werden. Der Wasser-/Wassertauscher müsste aufgrund des hohen Primärdrucks von 6 Bar außerhalb des Schaltschrankes liegen (zumindest der Primärkreislauf). Eine externe Temperaturfassung müsste das Management des Kühlkreislaufes übernehmen, damit es nicht zur Betauung kommen kann. In der Regel wird an Kunststoffmaschinen mit Vorlauftemperaturen von 6 C bis 15 C gearbeitet. Diese zusätzlichen Einheiten vergrößern den erforderlichen Schaltschrank. Dieses ist unerwünscht, da es heute immer mehr Bestrebungen zu dezentralen Lösungen gibt. Da der Schaltschrank an die Antriebsachse wandert, muss er möglichst kompakt sein. Darüber hinaus verteuern die zusätzlichen Einheiten die Antriebslösung nicht unerheblich, so dass auf einen sekundären Kreislauf verzichtet wird, mit entsprechenden Risiken für die Langlebigkeit einer Maschine.

Die vorliegende Erfindung basiert nun auf der Idee, auf einen zusätzlichen Wärmeübertrager zu verzichten. Vielmehr wird diese Einheit an dem zu kühlendem elektrischen oder elektronischen Gerät integriert. Das elektrische oder elektronische Gerät behält zunächst seinen eigentlichen Flüssigkeitskühlkörper, in der Regel Wasserkühlkörper, wobei der Wasserkühlkörper durch eine Öffnung in einem Schaltschrank nach außen vorsteht, d.h. wobei das elektrische oder elektronische Gerät in sogenannter Durchsteckversion aufgebaut ist. Der Flüssigkeitskühlkörper ist somit fester Bestandteil des elektrischen oder elektronischen Geräts und bildet den Sekundärkühlkörper des geplanten Flüssigkeits/Flüssigkeitstauschers. Der Sekundärkühlkörper kann verbunden werden mit einer Umwälzpumpe und einem Ausgleichsbehälter und/oder einem eventuell vorhandenen wassergekühlten Motor und/oder einem wassergekühlten Getriebe. Diese Einheiten bilden dann den Sekundärkreislauf. Auf dem sekundären Kühlkörper wird ein weiterer Flüssigkeitskühlkörper, in der Regel ein Wasserkühlkörper, befestigt, nämlich der Primärkühlkörper. Der Primärkühlkörper wird vorzugsweise schwimmend auf dem sekundären Kühlkörper befestigt und ist leicht abzunehmen. Er kann bei Bedarf geöffnet und dann gereinigt bzw. ausgetauscht werden.

Die vorliegende Erfindung ermöglicht zahlreiche Vorteile.

Zum einen bleibt das Ziel des Maschinenbauers erhalten, dahingehend, dass nur der Wärmetauscher für das Primärwasser anfällig ist, nämlich konkret die abnehmbare Primärkühlplatte. Ferner ist kein zusätzlicher Platzbedarf für den Wärmetauscher im Schaltschrank erforderlich. Darüber hinaus bleibt das Wasser mit einem Wasserdruck von 6 Bar generell außerhalb des Schaltschrankes. Der Wärmetauscher ist darüber hinaus leicht zugänglich, wobei der Primärkreislauf leicht demontierbar bzw. austauschbar ist und sich leicht öffnen und reinigen lässt. Ein Temperaturmanagement kann durch das elektrische oder elektronische Gerät, beispielsweise den Frequenzumrichter, mittels einer Temperaturerfassung und Auswertung erfolgen. Eine Betauung an der Maschine kann ausgeschlossen werden. Hinsichtlich des Ausgleichsbehälters und der Wärmepumpe können Komponenten aus dem Bereich Heizungsbau verwendet werden und somit millionenfach bewährte Technik zu günstigen Konditionen. Sekundärkreislauf-Komponenten können in den Schaltschrank mit eingebaut werden, da nur eine geringe Gefahr durch Leckagen besteht, da im Sekundärkreislauf ein druckschwacher Umwälzbetrieb vorherrscht. Der Sekundärkreislauf kann temperaturmäßig mittels der Regelgröße Kühltemperatur geregelt werden. Ferner kann der Sekundärkreislauf aus mehreren Frequenzumrichtern und Motoren/Getrieben bestehen.

Bevorzugte Ausführungsbeispiele der vorliegenden Erfindung werden nachfolgend bezugnehmend auf die beiliegenden Zeichnungen näher erläutert. Es zeigen:
- Fig. 1a, 1b und 1c: schematisch eine Vorderansicht, eine Draufsicht und eine Seitenansicht eines Ausführungsbeispiels einer erfindungsgemäßen Vorrichtung zum Kühlen;
- Fig. 2: unterschiedliche Ansichten eines Ausführungsbeispiels eines Primärkühlkörpers für eine erfindungsgemäße Vorrichtung zum Kühlen;
- Fig. 3a, 3b, 3c: unterschiedliche Ansichten eines Frequenzumrichters mit Sekundärkühlkörper und Primärkühlkörper; und
- Fig. 4: schematisch einen Ausschnitt einer Schaltschrankwand, die für ein Ausführungsbeispiel einer erfindungsgemäßen Vorrichtung zum Kühlen geeignet ist.

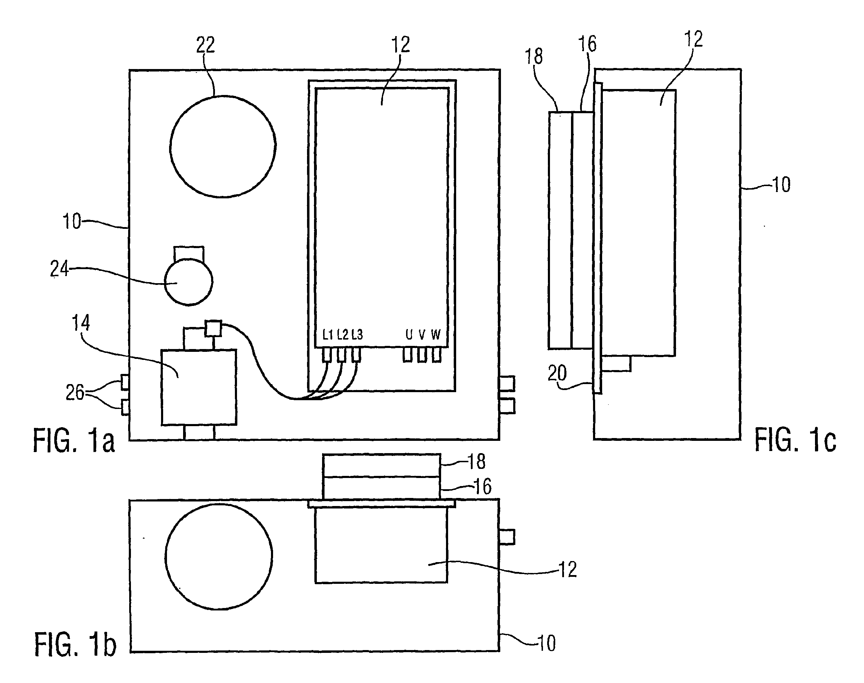

Anhand der Figuren 1a bis 1c wird zunächst ein Ausführungsbeispiel einer erfindungsgemäßen Vorrichtung zum Kühlen näher erläutert.

In einem Schaltschrank 10 ist ein Frequenzumrichter 12 angeordnet, der zur variablen Einstellung der Motordrehzahl eines Elektromotors (nicht gezeigt) bei vollem Drehmoment dient. Zwischen ein Netz und Versorgungsanschlüsse L1, L2 und L3 des Frequenzumrichters 12 ist dabei eine Drossel 14 geschaltet. An Anschlüssen U, V und W gibt der Frequenzumrichter 12 Ausgangssignale variabler Frequenz zum Steuern des Elektromotors aus.

Entsprechende Elektromotoren beispielsweise bei Kunststoffmaschinen besitzen hohe Leistungen beispielsweise im Bereich von 110 kW bis 160 kW und können folglich eine Verlustleistung im Frequenzumrichter von 4 kW zur Folge haben. Somit ist eine gute Kühlung des Frequenzumrichters erforderlich.

Zu diesem Zweck umfasst der Frequenzumrichter einen Wasserkühlkörper 16 für einen Sekundärkreislauf, der somit als Sekundärkühlkörper 16 bezeichnet werden kann. Auf dem Sekundärkühlkörper 16 ist ein Primärkühlkörper 18 angebracht. Wie den Figuren 1b und 1c zu entnehmen ist, ist der Frequenzumrichter in Durchsteckversion in den Schaltschrank eingebaut, derart, dass der Sekundärkühlkörper 16, oder zumindest Teile desselben, durch eine Öffnung in dem Schaltschrank 16 vorstehen. Zu diesem Zweck umfasst der Frequenzumrichter 12 beispielsweise einen Flansch 20, der mit den die Öffnung in dem Schaltschrank 10 umgebenden Bereichen verschraubt sein kann. Auf die freiliegende Oberfläche des Sekundärkühlkörpers 16 ist dann der Primärkühlkörper 18 geschraubt. Der Sekundärkühlkörper bildet zusammen mit einem Ausgleichsbehälter 22 und einer Umwälzpumpe 24 einen Sekundärkühlkreislauf. Die entsprechenden Fluidikverbindungen sind in den Figuren der Einfachheit halber nicht dargestellt. Ferner kann eine Temperatursteuerung für den Sekundärkreislauf vorgesehen sein. Beispielsweise kann das Temperaturmanagement für den Sekundärkreislauf, Temperaturerfassung und Auswertung, durch den Frequenzumrichter erfolgen. Ferner kann der Sekundärkühlkreislauf mit einem eventuell vorhandenen wassergekühlten Motor und/oder einem wassergekühlten Getriebe verbunden sein. Als Kühlmittel für den sekundären Kühlkreislauf kann beispielsweise destilliertes Wasser mit einem Glykolanteil verwendet werden.

Der Primärkühlkörper 18 kann über Fluidanschlüsse desselben (in den Figuren 1a bis 1c nicht dargestellt) mit einem Primärkreislauf verbunden sein, beispielsweise einem bei einem Benutzer vorhandenen Wasserkreislauf. Der den Primärkühlkörper beinhaltende Primärkühlkreis sowie der den Sekundärkühlkörper beinhaltende Sekundärkühlkreis stellen somit einen Wärmetauscher dar, über den der Frequenzumrichter gekühlt werden kann, ohne dass Komponenten des Frequenzumrichters bzw. mit demselben fest verbundene Komponenten, wie z.B. der Sekundärkühlkörper, mit der Kühlflüssigkeit des Primärkühlkreises in Berührung kommen. Der Primärkühlkörper 18 ist vorzugsweise unter Verwendung von Schrauben schwimmend an den Sekundärkühlkörper befestigt, so dass er leicht abzunehmen ist. Er kann somit ohne weiteres ausgetauscht werden. Ferner ist er vorzugsweise aufgebaut, um bei Bedarf geöffnet und gereinigt werden zu können.

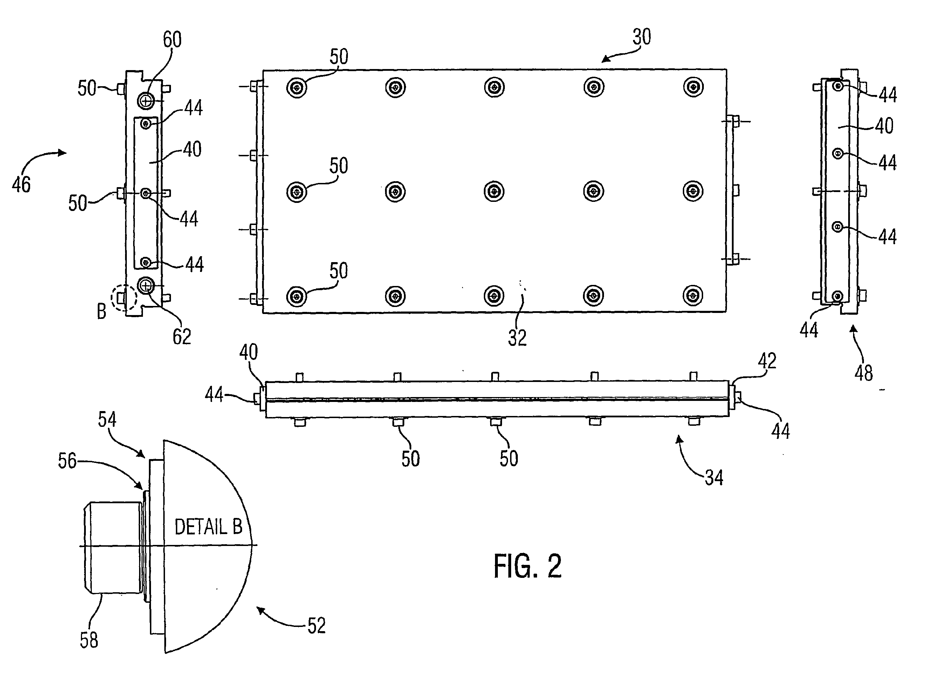

Unterschiedliche Ansichten eines Ausführungsbeispiels eines Primärkühlkörpers sind in Fig. 2 gezeigt. Bei 30 ist eine Draufsicht auf einen Primärkühlkörper 32 gezeigt, bei 34 ist eine Seitenansicht der unteren Seite, bei 36 eine Seitenansicht der linken Seite und bei 38 eine Seitenansicht der rechten Seite (ausgehend von der Darstellung des Kühlkörpers 32 bei 30) gezeigt.

Der Kühlkörper 32 weist einen plattenförmigen Aufbau auf und kann aus einem bearbeiteten Stranggussprofil bestehen. Alternative könnte der Kühlkörper auch aus mehreren Plattenhälften zusammengesetzt sein. In dem Kühlkörper sind die jeweiligen Fluidstrukturen (nicht gezeigt), die zu dem Primärkühlkreislauf beitragen, gebildet. Platten 40 und 42 decken die Enden des Stranggusskörpers ab und können beispielsweise aus Edelstahl bestehen. Hinter den Platten verborgen sind bearbeitete Kopfenden des Kühlkörpers, die eine Zwangsführung des Wassers durch den Kühlkörper ermöglichen. Die Platten 40 und 42 können unter Verwendung von Schrauben 44 angebracht sein, so dass durch Abnahme dieser Platten die Fluidstrukturen, d.h. Kanäle, in dem Kühlkörper 32, beispielsweise unter Verwendung einer Flaschenbürste oder eines Dorns, gereinigt werden können.

Durch den Primärkühlkörper 32 sind ferner Öffnungen vorgesehen, durch die der Primärkühlkörper mittels Schrauben 50 an einem Sekundärkühlkörper angebracht werden kann. Insbesondere kann der Primärkühlkörper 32 vorzugsweise schwimmend an den Sekundärkühlkörper angeschraubt werden, wobei ein hierfür verwendbares Schraubenelement als vergrößerte Darstellung 52 des Abschnitts B der Darstellung 36 in Fig. 2 gezeigt ist. Die schwimmende Verschraubung wird erreicht, indem neben einer Unterlegscheibe 54 ferner ein Federelement 56 bei der Verschraubung verwendet wird. Die Öffnungen durch den Primärkühlkörper sind bei Ausführungsbeispielen der Erfindung etwas größer als der Durchmesser des Schraubengewindes 58, so dass dort ein Spiel existiert und eine federnde Lagerung des Primärkühlkörpers möglich ist.

Durch die schwimmende Lagerung der Primärkühlplatte auf der Sekundärkühlplatte kann eine thermisch bedingte Verspannung zwischen den Platten verhindert werden. Dadurch wird ein Abwölben der Platten zueinander verhindert. Somit wird erreicht, dass eine optimale Wärmeübertragung zwischen den Platten gewährleistet ist.

In der linken oberen Darstellung 36 in Fig. 2 sind ferner zwei Rohrgewinde 60 und 62 dargestellt, die einen Fluidanschluss der in dem Primärkühlkörper 32 gebildeten Fluidleitungen (nicht gezeigt) an den Primärkühlkreislauf ermöglichen.

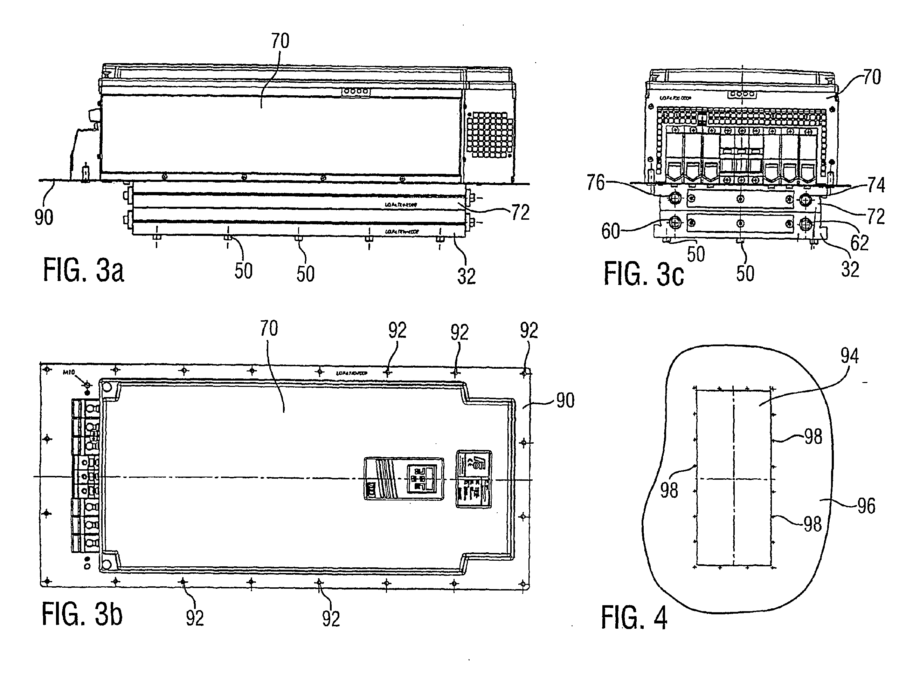

In den Figuren 3a, 3b und 3c sind Ansichten eines Frequenzumrichters mit Primärkühlkörper und Sekundärkühlkörper gezeigt. Dabei zeigt Fig. 3b eine Draufsicht auf einen Frequenzumrichter 70, während Fig. 3a eine Seitenansicht der in Fig. 3b unteren Seite und Fig. 3c eine Seitenansicht der in Fig. 3b rechten Seite zeigt.

Mit dem Frequenzumrichter fest verbunden ist ein Sekundärkühlkörper 72, wie insbesondere den Figuren 3a und 3c zu entnehmen ist. Der Sekundärkühlkörper kann einen Aufbau ähnlich dem oben beschriebenen Aufbau des Primärkühlkörpers aufweisen und ist ein fester Bestandteil des Frequenzumrichters. Wie in Fig. 3c gezeigt ist, kann der Sekundärkühlkörper Rohrgewinde 74 und 76 aufweisen, die einen Anschluss des Sekundärkühlkreislaufes an externe Fluidikstrukturen, d.h. beispielsweise Ausgleichsbehälter und Umwälzpumpe und/oder auch die Kühlungsstrukturen eines wassergekühlten Motors und/oder eines wassergekühlten Getriebes, ermöglichen.

An die Unterseite des Sekundärkühlkreislaufes 72 ist, beispielsweise unter Verwendung der bezugnehmend auf Fig. 2 beschriebenen Schrauben 50, der Primärkühlkörper 32 geschraubt. Wie oben bereits ausgeführt wurde, ist der wassergekühlte Frequenzumrichter 70 vorzugsweise in Durchsteckversion aufgebaut und in einem Schaltschrank angebracht. Diesbezüglich umfasst der Frequenzumrichter 70 einen Flansch 90, in dem eine Mehrzahl von Bohrungen 92 vorgesehen sind. Über diesen Flansch 90 kann der Frequenzumrichter derart an einer Schaltschrankwand befestigt werden, dass der Frequenzumrichter innerhalb des Schaltschranks angeordnet ist, während der Sekundärkühlkörper 72 außerhalb des Schaltschranks angeordnet ist. Diesbezüglich wird der Frequenzumrichter 70 von innen durch eine Öffnung 94 in eine Schaltschrankwand 96 (Fig. 4) gesteckt, so dass die Öffnungen 92 in dem Flansch 90 mit entsprechenden Öffnungen 98 in der Schaltschrankwand 96 ausgerichtet sind. Durch Verwendung entsprechender Befestigungsmittel, beispielsweise Schrauben und Gegenmuttern, kann der Frequenzumrichter dann an der Schaltschrankwand 96 fixiert werden.

Bei dem bevorzugten Ausführungsbeispiel sind sowohl Primärkühlkörper als auch Sekundärkühlkörper plattenförmig ausgebildet und an Hauptoberflächen derselben aneinander angebracht, so dass ein guter Wärmeaustausch zwischen Sekundärkühlkörper und Primärkühlkörper möglich ist. Somit kann eine effektive Kühlung des Frequenzumrichters unter Verwendung des Primärkühlkörpers und des Sekundärkühlkörpers realisiert werden.

## Patentansprüche

1. Vorrichtung zum Kühlen eines in einem Schaltschrank (10) angeordneten elektrischen oder elektronischen Geräts (12; 70), mit folgenden Merkmalen:
einem Sekundärkühlkörper (16; 72) für einen Sekundärkühlkreislauf, wobei der Sekundärkühlkörper (16; 72) an dem elektrischen oder elektronischen Gerät (12; 70) angebracht ist, um dasselbe zu kühlen, und wobei zumindest ein Abschnitt des Sekundärkühlkörpers (16; 72) durch eine Öffnung (94) in einer Wand (96) des Schaltschranks (10) aus demselben vorsteht; und
einem Primärkühlkörper (18; 32) für einen Primärkühlkreislauf, der auf dem aus dem Schaltschrank vorstehenden Abschnitt des Sekundärkühlkörpers (16; 72) abnehmbar angebracht ist, um denselben zu kühlen.

2. Vorrichtung nach Anspruch 1, bei der der Primärkühlkörper (18; 32) schwimmend auf dem Sekundärkühlkörper (16; 72) befestigt ist.

3. Vorrichtung nach Anspruch 1 oder 2, bei der der Primärkühlkörper (18; 32) plattenförmig ausgebildet ist, wobei eine Hauptoberfläche des Primärkühlkörpers (18; 32) an einer Hauptoberfläche des Sekundärkühlkörpers (16; 72) angebracht ist.

4. Vorrichtung nach einem der Ansprüche 1 bis 3, bei der das elektrische oder elektronische Gerät (12; 70) ein Frequenzumrichter ist, und bei der der Sekundärkühlkörper (16; 72) ein fester Bestandteil des Frequenzumrichters ist.

5. Vorrichtung nach einem der Ansprüche 1 bis 4, bei der Fluidbereiche des Sekundärkühlkörpers (16; 72) fluidisch mit einem Ausgleichsbehälter (22) und einer Umwälzpumpe (24) verbunden sind.

6. Vorrichtung nach Anspruch 5, bei der der Ausgleichsbehälter (22) und die Umwälzpumpe (24) in dem Schaltschrank (10) angeordnet sind.

7. Vorrichtung nach einem der Ansprüche 1 bis 6, bei der Fluidbereiche des Sekundärkühlkörpers (16; 72) fluidisch mit einem wassergekühlten Motor und/oder einem wassergekühlten Getriebe verbunden sind.

8. Vorrichtung nach einem der Ansprüche 1 bis 7, bei der Fluidbereiche des Primärkühlkörpers fluidisch mit einem Wasserkreislauf einer externen Maschine verbunden sind.

9. Vorrichtung nach einem der Ansprüche 1 bis 8, bei der die externe Maschine eine Kunststoffbearbeitungsmaschine ist.

## Claims

1. Apparatus for cooling an electrical or electronical device (12; 17) arranged in a switch cabinet (10), comprising:
a secondary cooling element (16; 72) for a secondary cooling cycle, wherein the secondary cooling element (16; 72) is attached at the electrical or electronical device (12; 17) in order to cool same, and wherein at least a portion of the secondary cooling element (16; 72) protrudes through an opening (94) in a wall (96) of the switch cabinet (10) therefrom; and
a primary cooling element (18; 32) for a primary cooling cycle, which is removably attached at the portion of the secondary cooling element (16; 72) protruding from the switch cabinet in order to cool same.

2. Apparatus according to claim 1, wherein the primary cooling element (18; 32) is floatingly mounted on the secondary cooling element (16; 72).

3. Apparatus according to claim 1 or 2, wherein the primary cooling element (18; 32) is formed to be plate-shaped, wherein a main surface of the primary cooling element (18; 32) is attached at a main surface of the secondary cooling element (16; 72).

4. Apparatus according to one of claims 1 to 3, wherein the electrical or electronical device (12; 70) is a frequency inverter, and wherein the secondary cooling element (16; 72) is an integral part of the frequency inverter.

5. Apparatus according to one of claims 1 to 4, wherein fluid regions of the secondary cooling element (16; 72) are fluidically connected to a compensation container (22) and a circulation pump (24).

6. Apparatus according to claim 5, wherein the compensation container (22) and the circulation pump (24) are arranged in the switch cabinet (10).

7. Apparatus according to one of claims 1 to 6, wherein fluid regions of the secondary cooling element (16; 72) are fluidically connected to a water-cooled motor and/or a water-cooled gear.

8. Apparatus according to one of claims 1 to 7, wherein fluid regions of the primary cooling element are fluidically connected to a water cycle of an external machine.

9. Apparatus according to one of claims 1 to 8, wherein the external machine is a plastics processing machine.

## Revendications

1. Dispositif destiné à refroidir un appareil électrique ou électronique (12; 70) disposé dans une armoire électrique (10), aux caractéristiques suivantes:
un corps de refroidissement secondaire (16; 72) d'un circuit de refroidissement secondaire, le corps de refroidissement secondaire (16; 72) étant placé sur l'appareil électrique ou électronique (12; 70), pour refroidir ce dernier, et au moins un segment du corps de refroidissement secondaire (16; 72) ressort à travers d'une ouverture (94) dans la parois (96) de l'armoire électrique (10) de ce dernier; et
un corps de refroidissement primaire (18; 32) d'un circuit de refroidissement primaire qui est placé de manière amovible sur le segment du corps de refroidissement secondaire (16; 72) ressortant de l'armoire électrique, pour refroidir ce dernier.

2. Dispositif selon la revendication 1, dans lequel le corps de refroidissement primaire (18; 32) est fixé flottant sur le corps de refroidissement secondaire (16; 72).

3. Dispositif selon la revendication 1 ou 2, dans lequel le corps de refroidissement primaire (18; 32) est réalisé en forme de plaque, une surface principale du corps de refroidissement primaire (18; 32) étant placée sur une surface principale du corps de refroidissement secondaire (16; 72).

4. Dispositif selon l'une des revendications 1 à 3, dans lequel l'appareil électrique ou électronique (12; 70) est un convertisseur de fréquence, et dans lequel le corps de refroidissement secondaire (16; 72) est un composant fixe du convertisseur de fréquence.

5. Dispositif selon l'une des revendications 1 à 4, dans lequel des zones de fluide du corps de refroidissement secondaire (16; 72) sont en connexion de fluide avec un réservoir de compensation (22) et une pompe de recirculation (24).

6. Dispositif selon la revendication 5, dans lequel le réservoir de compensation (22) et la pompe de recirculation (24) sont disposés dans l'armoire électrique (10).

7. Dispositif selon l'une des revendications 1 à 6, dans lequel les zones de fluide du corps de refroidissement secondaire (16; 72) sont en connexion de fluide avec un moteur refroidi par de l'eau et/ou un engrenage refroidi par de l'eau.

8. Dispositif selon l'une des revendications 1 à 7, dans lequel les zones de fluide du corps de refroidissement primaire sont en connexion de fluide avec un circuit d'eau d'une machine externe.

9. Dispositif selon l'une des revendications 1 à 8, dans lequel la machine externe est une machine d'usinage de matières plastiques.
